(19) Europäisches Patentamt / European Patent Office / Office européen des brevets

(11) **EP 2 525 402 B1**

(12) **FASCICULE DE BREVET EUROPEEN**

(45) Date de publication et mention
de la délivrance du brevet:
**01.01.2020 Bulletin 2020/01**

(51) Int Cl.:
***H01L 23/62*** *(2006.01)*     ***H01L 23/498*** *(2006.01)*
***H01L 23/13*** *(2006.01)*     ***H01L 23/373*** *(2006.01)*

(21) Numéro de dépôt: **12168045.8**

(22) Date de dépôt: **15.05.2012**

(54) **DISPOSITIF D'ISOLATION ELECTRIQUE A TENSION DE CLAQUAGE AMELIOREE**

ELEKTRISCHE ISOLIERVORRICHTUNG MIT VERBESSERTER DURCHSCHLAGSSPANNUNG

ELECTRICAL INSULATION DEVICE WITH IMPROVED BREAKDOWN VOLTAGE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **17.05.2011 FR 1154282**

(43) Date de publication de la demande:
**21.11.2012 Bulletin 2012/47**

(73) Titulaire: **ALSTOM Transport Technologies
93400 Saint-Ouen (FR)**

(72) Inventeurs:
• **Dagdag, Selim
65000 Tarbes (FR)**
• **Nagata, Michikazu
Kagoshima 895-0292 (JP)**
• **Chauchat, Bertrand
65360 Salles Adour (FR)**
• **Nicolau, Sébastien
65100 Loubajac (FR)**
• **Hamachi, Toshiyuki
Kagoshima 895-0292 (JP)**

(74) Mandataire: **Lavoix
2, place d'Estienne d'Orves
75441 Paris Cedex 09 (FR)**

(56) Documents cités:
**EP-A2- 1 818 980**     **WO-A1-2011/040054**
**DE-A1-102008 026 347**     **US-A1- 2002 066 953**
**US-A1- 2010 065 962**     **US-B1- 6 597 063**

**EP 2 525 402 B1**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

La présente invention concerne un dispositif d'isolation électrique d'un plan électriquement conducteur propre à présenter un premier potentiel électrique par rapport à un deuxième potentiel électrique, le dispositif comprenant:

- un substrat isolant comportant deux surfaces planes parallèles l'une de l'autre,
- une première couche extérieure, électriquement conductrice, sensiblement plane et disposée sur une première surface plane du substrat isolant, la première couche extérieure formant le plan électriquement conducteur propre à être relié au premier potentiel et présentant un bord périphérique,

la seconde surface étant propre à être reliée au deuxième potentiel électrique (V2).

L'invention concerne également un système d'alimentation électrique de composants électroniques comprenant un tel dispositif d'isolation électrique.

L'invention concerne également l'utilisation de N zones électriquement conductrices, N étant supérieur ou égal à 2, distinctes de la première couche extérieure électriquement conductrice d'un tel dispositif d'isolation électrique pour diminuer la valeur du champ électrostatique en un point du bord périphérique de la première couche extérieure.

On connaît un dispositif d'isolation électrique du type précité. Le dispositif d'isolation électrique comprend un substrat isolant comportant deux surfaces planes parallèles l'une de l'autre, et deux couches électriquement conductrices sensiblement planes, chacune étant disposée sur une surface plane correspondante du substrat isolant. Chaque couche conductrice présente un bord périphérique, et le bord périphérique de la seconde couche est sensiblement identique à la translatée du bord périphérique de la première couche suivant une direction normale au plan de la première couche. La première couche est au premier potentiel, et la deuxième couche est au deuxième potentiel électrique. Le substrat isolant est en nitrure d'aluminium (AlN), en oxyde d'aluminium ($Al_2O_3$), ou encore en nitrure de silicium ($Si_3N_4$).

Un tel dispositif d'isolation électrique présente une rigidité diélectrique relativement faible, par exemple de l'ordre de 15 kV/mm pour une épaisseur d'un millimètre, et est susceptible de subir une détérioration pour une tension, appelée tension de claquage, de valeur relativement faible, de l'ordre de 15 kV pour une épaisseur d'un millimètre dans l'exemple précité. L'épaisseur du substrat isolant entre les deux surfaces planes doit alors être augmentée pour obtenir une tension de claquage plus importante, afin que le dispositif d'isolation ne soit pas détérioré lorsqu'une différence de potentiel élevée est appliquée. Le substrat d'un tel dispositif présente de ce fait une épaisseur d'environ 10 mm pour ne pas être détérioré vis-à-vis d'une différence de potentiel d'environ 45 kV entre les deux couches conductrices extérieures.

Toutefois, l'augmentation de l'épaisseur du substrat isolant pour avoir une tension de claquage plus élevée entraîne une augmentation de la résistance thermique du substrat, ce qui engendre un moindre refroidissement des composants électroniques fixés sur la première couche conductrice, et donc une augmentation de leur température.

US 2002/066953 A1 décrit également un dispositif d'isolation électrique du type précité.

Le but de l'invention est de proposer un dispositif d'isolation électrique présentant une tension de claquage plus élevée tout en conservant une même épaisseur de substrat, afin de ne pas augmenter la résistance thermique du substrat.

A cet effet, l'invention a pour objet un dispositif d'isolation électrique selon la revendication 1.

Suivant d'autres modes de réalisation, le dispositif d'isolation électrique est selon l'une quelconque des revendications 2 à 8.

L'invention a également pour objet un système d'alimentation électrique selon la revendication 9.

L'invention a également pour objet l'utilisation de N zones électriquement conductrices distinctes, N étant supérieur ou égal à 2, selon la revendication 10.

Ces caractéristiques et avantages de l'invention apparaîtront à la lecture de la description qui va suivre, donnée uniquement à titre d'exemple, et faite en référence aux dessins annexés, sur lesquels :

- la figure 1 est une représentation schématique d'un système d'alimentation électrique de composants électroniques, le système comprenant un dispositif d'isolation électrique selon l'invention,
- la figure 2 est une représentation schématique, en coupe suivant un plan vertical, du dispositif d'isolation de la figure 1,
- la figure 3 est une représentation des lignes de champ électrostatique au voisinage d'un bord de couches conductrices du dispositif d'isolation de la figure 2, et
- la figure 4 est une vue analogue à celle de la figure 2 selon un premier mode de réalisation de l'invention,
- la figure 5 est une vue analogue à celle de la figure 3 selon le premier mode de réalisation de l'invention,
- la figure 6 est une vue analogue à celle de la figure 2 selon un deuxième mode de réalisation de l'invention,
- la figure 7 est une vue analogue à celle de la figure 2 selon un autre mode de réalisation qui ne fait pas partie de l'invention, et
- la figure 8 est une vue analogue à celle de la figure 2 selon encore un autre mode de réalisation qui ne fait pas partie de l'invention.

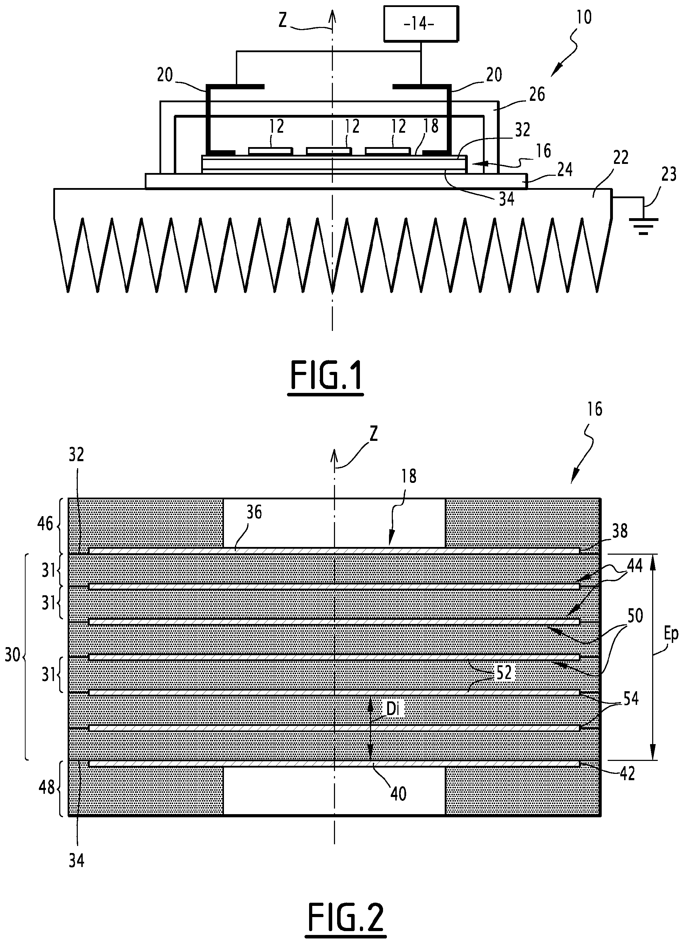

Sur la figure 1, un système 10 d'alimentation électrique de composants électroniques 12 comprend une source d'alimentation électrique 14, un dispositif d'isolation électrique 16 comportant un plan conducteur 18 de connexion électrique des composants électroniques 12, et des bornes 20 de connexion électrique du plan conducteur à la source d'alimentation.

Le système d'alimentation électrique 10 comprend un radiateur 22 de dissipation de l'énergie thermique dégagée par les composants électroniques, le radiateur 22 étant relié à une masse électrique 23, et une semelle 24 de fixation du dispositif d'isolation électrique au radiateur. Le système d'alimentation électrique 10 comprend un boitier 26 de protection des composants électroniques et du dispositif d'isolation, le boitier de protection 26 étant fixé à la semelle 24.

Les composants électroniques 12 sont, par exemple, des transistors de puissance, chacun comportant une face inférieure, une face supérieure et une face latérale. Chaque transistor présente sur sa face inférieure une électrode de collecteur, et sur sa face supérieure les électrodes de grille et d'émetteur. Dans l'exemple de réalisation de la figure 1, les transistors 12 sont connectés en parallèle, les électrodes de collecteur étant connectées électriquement au plan conducteur 18. Les connexions électriques avec les électrodes de grille pour la commande des transistors et d'émetteur pour la sortie du courant, agencées sur la face supérieure des transistors, ne sont pas représentées sur la figure 1. Les composants électroniques 12 sont, par exemple, des composants propres à permettre la circulation d'un courant électrique présentant une tension de 3,3 kV, ou encore de 6,6 kV.

La source d'alimentation 14 est une source d'alimentation électrique haute tension propre à délivrer une tension électrique de l'ordre de 25 kV, correspondant à un premier potentiel électrique V1.

Le dispositif d'isolation électrique 16 isole le plan conducteur 18 propre à présenter le premier potentiel électrique V1 par rapport à un deuxième potentiel électrique V2. Le dispositif d'isolation électrique 16 comprend un substrat isolant 30 comportant un empilement de strates isolantes 31, une première surface plane 32 et une seconde surface plane 34, les surfaces planes 32, 34 étant parallèles l'une de l'autre. La seconde surface 34 est reliée au deuxième potentiel électrique V2, tel que par exemple le potentiel nul de la masse électrique 23.

Un axe vertical Z perpendiculaire à la première surface plane 32 est représenté sur la figure 1.

Le dispositif d'isolation électrique 16, représenté sur la figure 2, en coupe suivant un plan vertical passant par l'axe vertical Z, comprend en outre une première couche extérieure 36, électriquement conductrice, sensiblement plane et disposée sur la première surface 32 du substrat isolant, la première couche extérieure 36 présentant un bord périphérique 38 selon une direction radiale par rapport à l'axe vertical Z.

En complément, le dispositif d'isolation électrique 16 comprend une seconde couche extérieure 40, électriquement conductrice, sensiblement plane et disposée sur la seconde surface 34 du substrat isolant, la seconde couche extérieure 40 présentant un bord périphérique 42 selon une direction radiale par rapport à l'axe vertical Z.

Le dispositif d'isolation électrique 16 comprend également des moyens 44 de diminution de la valeur du champ électrostatique en un point du bord périphérique 38, 42 de la couche extérieure 36, 40.

En complément, le dispositif d'isolation électrique 16 comprend une première bordure 46 de recouvrement du bord périphérique 38 de la première couche extérieure, et une seconde bordure 48 de recouvrement du bord périphérique 42 de la seconde couche extérieure, les bordures de recouvrement 46, 48 étant électriquement isolantes.

Le substrat isolant 30 est réalisé, par exemple, en nitrure d'aluminium (AIN), ou en oxyde d'aluminium ($Al_2O_3$), ou en nitrure de silicium ($Si_3N_4$), ou encore en alumine monocristalline, également appelée saphir. Le substrat isolant 30 est de préférence en nitrure d'aluminium. Le substrat isolant 30 présente, par exemple, une épaisseur Ep sensiblement égale à 3,5 mm.

La première couche extérieure 36 forme le plan électriquement conducteur 18 relié au premier potentiel V1 correspondant à la source d'alimentation 14. La première couche extérieure 36 forme une piste de circulation d'un courant électrique, tel que le courant électrique délivré par la source d'alimentation 14, et constitue l'unique piste de circulation de courant du dispositif 16.

La première couche extérieure 36 est, par exemple, une couche pleine, c'est-à-dire une couche occupant intégralement l'aire délimitée intérieurement par rapport au bord périphérique 38. Le bord périphérique 38 de la première couche est en forme d'une ligne fermée, par exemple en forme d'un cercle ou d'un polygone. Le bord périphérique 38 est de préférence symétrique par rapport à l'axe vertical médian Z. Dans l'exemple de réalisation de la figure 2, le bord périphérique 38 est en forme d'un carré à angles arrondis.

La seconde couche extérieure 40 est sensiblement plane et, est par exemple, une couche pleine. Le bord périphérique 42 de la seconde couche extérieure est, par exemple, de forme identique au bord périphérique 38 de la première couche extérieure. Plus précisément, le bord périphérique 42 de la seconde couche est, dans l'exemple de réalisation de la figure 2, identique à la translatée du bord périphérique 38 de la première couche suivant la direction verticale Z, perpendiculaire au plan de la première couche extérieure 36.

En variante, le bord périphérique 42 de la seconde couche est distinct de la translatée du bord périphérique 38. Autrement dit, le bord périphérique 42 est décalé du bord périphérique 38 radialement vers l'extérieur du dispositif par rapport à l'axe Z, ou bien décalé du bord périphérique 38 radialement vers l'intérieur du dispositif par rapport à l'axe Z.

Les premières et secondes couches 36, 40 sont obtenues par métallisation du substrat isolant 30, et présentent une épaisseur de quelques micromètres.

Les premières et secondes couches 36, 40 sont, par exemple, réalisées en tungstène ou en molybdène.

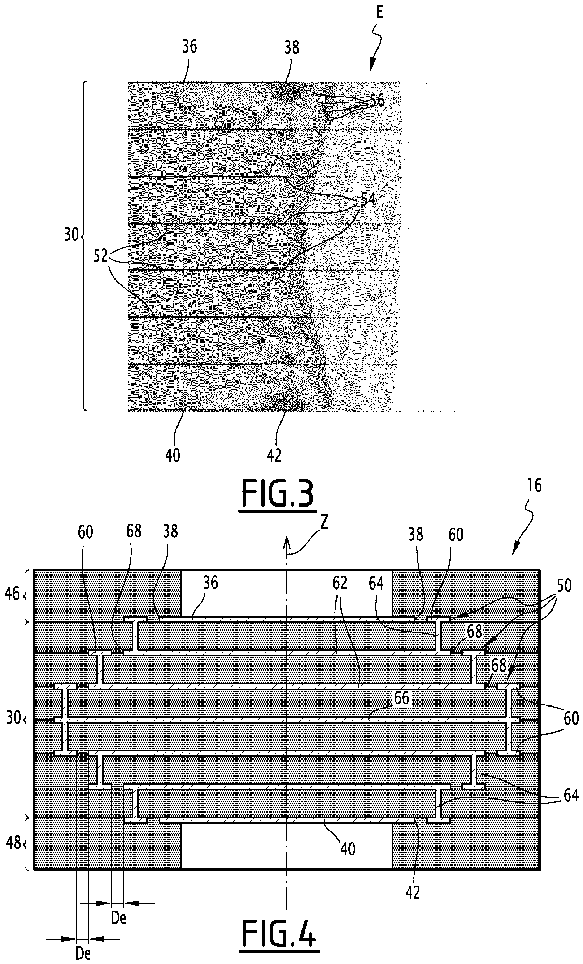

Les moyens de diminution 44 comportent au moins une zone électriquement conductrice 50 distincte des couches extérieures 36, 40, et disposée sur la première surface plane 32 du substrat isolant et/ou dans le substrat isolant 30. Les moyens de diminution 44 sont propres à diminuer la valeur du champ électrostatique E, visible sur la figure 3 représentant les lignes du champ électrostatique E, en un point du bord périphérique 38, 42 par rapport à la valeur du champ électrostatique en ce point en l'absence de zone conductrice distincte des couches extérieures. La zone conductrice 50 est propre à présenter un potentiel électrique Vi de valeur strictement comprise entre les valeurs des premier et deuxième potentiels électriques V1, V2.

Dans l'exemple de réalisation de la figure 2, les moyens de diminution 44 comportent cinq zones conductrices 50, et chaque zone conductrice 50 est en forme d'une couche intermédiaire 52, électriquement conductrice et disposée dans le substrat isolant 30 parallèlement à la première couche extérieure 36. Chaque couche intermédiaire 52 s'étend au moins jusqu'à la translatée dans le plan de la couche intermédiaire 52 du bord périphérique 38 de la première couche extérieure suivant l'axe Z normal au plan de la première couche extérieure 36.

Chaque couche intermédiaire 52 présente, par exemple, un bord périphérique 54 sensiblement identique à la translatée du bord périphérique 38 de la première couche extérieure 36 suivant la direction de l'axe Z perpendiculaire au plan de la première couche extérieure 36.

Les couches intermédiaires 52 sont obtenues par des métallisations successives des différentes strates isolantes 31 formant le substrat isolant. Chaque couche intermédiaire 52 est, par exemple, réalisée en tungstène ou en molybdène.

Ainsi, lorsque la source d'alimentation 14 applique une tension électrique au plan conducteur 18 par l'intermédiaire des bornes de connexion 20, la première couche extérieure 36 présente le premier potentiel électrique V1. La seconde couche extérieure 40 présente le second potentiel électrique V2, de valeur nulle dans l'exemple de réalisation des figures 1 à 3 où la seconde couche extérieure 40 est reliée électriquement à la semelle 24, elle-même reliée électriquement à la masse électrique 23.

Le vecteur représentant le champ électrostatique E en un point du substrat vérifie l'équation suivante :

$$\vec{E} = -\overrightarrow{grad}(V) \tag{1}$$

où V représente le potentiel électrique audit point du substrat.

Sur la figure 3 représentant des lignes 56 du champ électrostatique E, les zones sombres au voisinage des bords périphériques 38, 42, 54 représentent les zones où le champ électrostatique E est de valeur plus élevée, tandis que les zones plus claires correspondent aux zones où le champ électrostatique est plus faible.

Au voisinage de l'axe vertical médian Z, la valeur du potentiel électrique Vi d'un point dans le substrat isolant est une valeur comprise entre les potentiels V1 et V2, plus précisément une fonction linéaire de la distance entre ledit point et les couches extérieures 36, 40. La valeur du potentiel Vi au voisinage de l'axe Z vérifie alors l'équation suivante :

$$Vi = V2 + \frac{(V1 - V2) \times Di}{Ep} \tag{2}$$

où Di représente la distance entre le point où est déterminé le potentiel et la seconde couche extérieure 40, et Ep représente l'épaisseur du substrat isolant 30, c'est-à-dire la distance séparant les première et seconde couches extérieures 36, 40.

Chaque couche intermédiaire 52 présente alors le potentiel électrique Vi obtenu à l'aide de l'équation (2) en fonction de l'espacement Di entre la couche intermédiaire 52 respective et la seconde couche extérieure 40.

La valeur du potentiel électrique en un point de chaque bord périphérique 54 d'une couche intermédiaire est alors égale à la valeur du potentiel électrique pour cette couche intermédiaire 52 au voisinage de l'axe médian Z, déterminée à l'aide de l'équation (2). Autrement dit, la valeur du potentiel électrique est imposée dans le plan de la couche intermédiaire 52 depuis l'axe médian Z jusqu'au bord périphérique 54, alors que dans le dispositif d'isolation électrique de l'état de la technique la ligne de potentiel est sensiblement parallèle aux couches conductrices extérieures au voisinage de l'axe médian, puis, en s'éloignant de l'axe Z, tend à se rapprocher du bord périphérique 38, 42 de la couche extérieure 36, 40 la plus proche.

Chaque zone électriquement conductrice 50 permet d'éviter que les lignes de potentiel ne se rapprochent trop rapidement du bord périphérique 38, 42 de la couche extérieure correspondante, en imposant le potentiel électrique jusqu'à son bord périphérique 54. Autrement dit, chaque zone conductrice 50 permet d'écarter les lignes de potentiel par rapport aux lignes de potentiel du dispositif d'isolation électrique de l'état de la technique comportant seulement les premières et secondes couches extérieures, en l'absence de zone conductrice additionnelle.

Chaque zone conductrice 50 permet ainsi, d'après l'équation (1), de diminuer la valeur du champ électrostatique E au niveau des bords périphériques 38, 42 des premières et secondes couches extérieures 36, 40.

Ainsi, avec ce dispositif d'isolation électrique, la tension électrique entraînant une détérioration de la première couche extérieure 36, également appelée tension de claquage, est, pour une même épaisseur de substrat, de valeur plus importante que la valeur de tension de claquage du dispositif d'isolation électrique de l'état de la technique.

En effet, la détérioration de la première couche extérieure 36 se produit lorsque la valeur du champ électrostatique est supérieure à la rigidité diélectrique du matériau du substrat isolant 30. Or, la valeur du champ électrostatique au voisinage du bord périphérique 38 de la première couche est, pour une même épaisseur du substrat isolant 30 et pour des mêmes valeurs des premier et second potentiels V1, V2, plus faible avec le dispositif d'isolation selon l'invention qu'avec le dispositif d'isolation de l'état de la technique d'après ce qui précède. Autrement dit, ce dispositif d'isolation électrique supporte une différence de potentiel plus importante entre sa première couche extérieure et sa seconde surface plane sans engendrer de rupture diélectrique, également appelée claquage, du dispositif d'isolation.

On conçoit ainsi que le dispositif d'isolation électrique selon l'invention présente une tension de claquage plus importante tout en conservant une même épaisseur de substrat, afin de ne pas augmenter la résistance thermique du substrat.

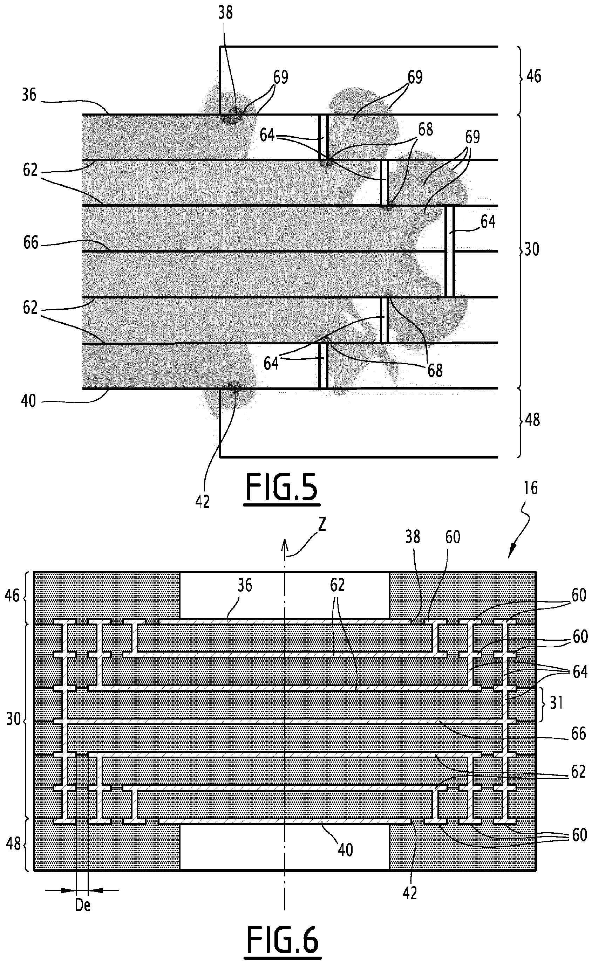

Les figures 4 et 5 illustrent un premier mode de réalisation de l'invention pour lequel les éléments analogues au mode de réalisation décrit précédemment, sont repérés par des références identiques, et ne sont donc pas décrits à nouveau.

Selon le premier mode de réalisation, chaque zone conductrice 50 comporte un anneau de garde 60 et une couche intermédiaire 62, électriquement conductrice et disposée dans le substrat isolant 30 parallèlement à la première couche extérieure 36. Chaque zone conductrice 50 comporte également une liaison 64 de connexion de l'anneau de garde 60 à la couche intermédiaire 62 correspondante.

Dans l'exemple de réalisation de le figure 4, le nombre N de zones conductrices 50 est égal à 5.

Dans la suite de la description, un anneau de garde désigne une partie conductrice entourant une couche conductrice, l'anneau de garde n'étant pas nécessairement en forme d'un anneau circulaire. Dans les exemples de réalisation des figures 4 à 8, les anneaux de garde 60 sont de forme carrée à angles arrondis, les couches conductrices étant de forme carrée. Chaque anneau de garde 60 est obtenu par métallisation d'une strate isolante 31 correspondante du substrat isolant. Chaque anneau de garde 60 est, par exemple, réalisé en tungstène ou en molybdène.

Un anneau de garde 60 est disposé dans le plan de chaque couche conductrice 36, 40, 62 à l'exception d'une couche intermédiaire centrale 66 disposée sensiblement à mi-distance entre la première et la seconde couche extérieure 36, 40. Chaque couche intermédiaire 62 présente un bord périphérique 68, l'anneau de garde 60 est sensiblement parallèle au bord périphérique 38, 42, 68 de la couche conductrice correspondante. L'espacement entre le bord périphérique 38, 42, 68 de la couche conductrice correspondante et l'anneau de garde 60 est égal à une distance prédéterminée De.

Chaque anneau de garde 60 est électriquement connecté à une couche intermédiaire 62 présentant un potentiel électrique différent de celui de la couche conductrice 36, 40, 62 autour de laquelle il est agencé.

Chaque liaison de connexion 64 comporte, par exemple, un via métallisé. Dans l'exemple de réalisation de la figure 4, chaque liaison de connexion 64 comporte deux vias métallisés disposés dans le plan de coupe de la figure 4 et diamétralement opposés par rapport à l'axe vertical Z. En variante, la liaison de connexion 64 est constituée d'un unique via. En variante encore, la liaison de connexion 64 comporte quatre vias métallisés équirépartis autour de l'axe Z, i.e. présentant un angle de 90° entre deux vias successifs.

Ainsi, chaque zone conductrice 50 permet d'imposer un potentiel électrique de valeur constante et distincte de celle des autres zones 50, la valeur du potentiel électrique d'une zone conductrice correspondante étant déterminée par la valeur du potentiel électrique de la couche intermédiaire 62 de la zone conductrice au voisinage de l'axe médian Z à l'aide de la formule (2) décrite précédemment pour le premier mode de réalisation.

Les valeurs des potentiels électriques Vi des zones conductrices 50 sont décroissantes depuis le bord 38 de la première couche extérieure 36 vers l'extérieur du dispositif 16 et vers la seconde couche extérieure 40.

Le fonctionnement de ce premier mode de réalisation est analogue à celui du mode de réalisation représenté dans les figures 1 et 2, les zones conductrices 50 permettant d'écarter les lignes de potentiels par rapport à un dispositif d'isolation électrique de l'état de la technique comportant seulement les couches conductrices extérieures en l'absence de zone conductrice additionnelle. La valeur du champ électrostatique au voisinage des bords périphériques 38, 42, 68 est alors réduite pour une même épaisseur Ep de substrat isolant 30 et des mêmes valeurs des premier et second potentiels électriques V1, V2.

Les zones conductrices 50 permettent d'imposer une valeur de potentiel électrique distincte des premier et deuxième potentiels électriques V1, V2, y compris dans le plan des première et secondes couches extérieures 36, 40 de par les anneaux de garde 60. La valeur du champ électrostatique au voisinage des bords périphériques 38, 42 est donc davantage réduite avec le dispositif d'isolation selon le premier mode de réalisation qu'avec le dispositif d'isolation selon le mode de réalisation représenté dans les figures 1 et 2, comme montré sur la figure 5 représentant des lignes 69 de champ électrostatique, où les zones au voisinage des bords périphériques 38, 42, 54 sont moins sombres que les zones correspondantes de la figure 3. L'homme du métier remarquera également que ces zones sont de dimensions plus réduites que les zones correspondantes de la figure 3.

La figure 6 illustre un deuxième mode de réalisation de l'invention pour lequel les éléments analogues au premier mode de réalisation décrit précédemment, sont repérés par des références identiques, et ne sont donc pas décrits à nouveau.

Selon le deuxième mode de réalisation, chaque zone conductrice 50 comporte au moins un anneau de garde 60 et une couche intermédiaire 62, électriquement conductrice et disposée dans le substrat isolant 30 parallèlement à la première couche extérieure 36. Chaque zone conductrice 50 comporte également une liaison 64 de connexion du ou de chaque anneau de garde 60 à la couche intermédiaire 62 correspondante.

Dans l'exemple de réalisation de le figure 6, le nombre N de zones conductrices 50 est égal à 5.

Un anneau de garde 60 est disposé dans le plan de chaque couche conductrice 36, 40, 62 à l'exception d'une couche intermédiaire centrale 66 disposée sensiblement à mi-distance entre la première et la seconde couche extérieure 36, 40. Chaque couche intermédiaire 62 présente un bord périphérique 68, et l'espacement entre le bord périphérique 38, 42, 68 de la couche conductrice correspondante et l'anneau de garde 60 est égal à une distance prédéterminée De.

Une pluralité P d'anneaux de garde 60 sont disposés dans le plan des couches extérieures 36, 40, les P anneaux de garde étant espacés les uns des autres et du bord périphérique 38, 42 de la couche extérieure 36, 40 correspondante. Les P anneaux de garde 60 entourent de manière concentrique la couche extérieure 36, 40 correspondante, en étant sensiblement parallèles les uns par rapport aux autres, ainsi que par rapport au bord périphérique 38, 42 de la couche extérieure 36, 40 correspondante. Le nombre P d'anneaux de garde 60 est décroissant depuis le plan des couches extérieures 36, 40 jusqu'au plan de la couche intermédiaire centrale 66 ne comportant pas d'anneau de garde.

Dans l'exemple de réalisation de la figure 6, P est égal à 3. Les plans des deux couches intermédiaires 62 les plus proches des couches extérieures 36, 40 comportent deux anneaux de garde 60, les plans des couches intermédiaires 62 suivantes comportant un anneau de garde 60, et le plan de la couche intermédiaire centrale 66 ne comportant pas d'anneau de garde.

Chaque anneau de garde 60 est électriquement connecté à une couche intermédiaire 62 présentant un potentiel électrique différent de celui de la couche conductrice 36, 40, 62 autour de laquelle il est agencé, et par l'intermédiaire d'un autre anneau de garde 60 lorsque la couche intermédiaire 62 à laquelle est connecté l'anneau de garde 60 n'est pas voisine du plan de l'anneau de garde.

Chaque liaison de connexion 64 reliant un anneau de garde 60 à une couche intermédiaire 62, ou bien deux anneaux de garde 60 appartenant à des plans différents, comporte, par exemple, un via métallisé. Dans l'exemple de réalisation de la figure 6, chaque liaison de connexion 64 comporte deux vias métallisés disposés dans le plan de coupe de la figure 4 et diamétralement opposés par rapport à l'axe vertical Z. En variante, la liaison de connexion 64 est constituée d'un unique via. En variante encore, la liaison de connexion 64 comporte quatre vias métallisés équirépartis autour de l'axe Z.

Les valeurs des potentiels électriques Vi des zones conductrices 50 sont décroissantes depuis le bord 38 de la première couche extérieure 36 vers l'extérieur du dispositif 16 et vers la seconde couche extérieure 40.

Le fonctionnement de ce deuxième mode de réalisation est analogue à celui du premier mode de réalisation, et n'est donc pas décrit à nouveau.

Les zones conductrices 50 comportant chacune un anneau de garde 60 dans le plan d'une des couches extérieures 36, 40 permettent d'imposer des valeurs de potentiel électrique distinctes des premier et deuxième potentiels électriques V1, V2 également dans le plan des première et secondes couches extérieures 36, 40, ce qui permet d'écarter les lignes davantage encore que dans le cas du premier mode de réalisation.

La valeur du champ électrostatique au voisinage des bords périphériques 38, 42 et des anneaux de garde 60 est donc davantage réduite avec le dispositif d'isolation selon le troisième mode de réalisation qu'avec le dispositif d'isolation selon les premier et deuxième modes de réalisation.

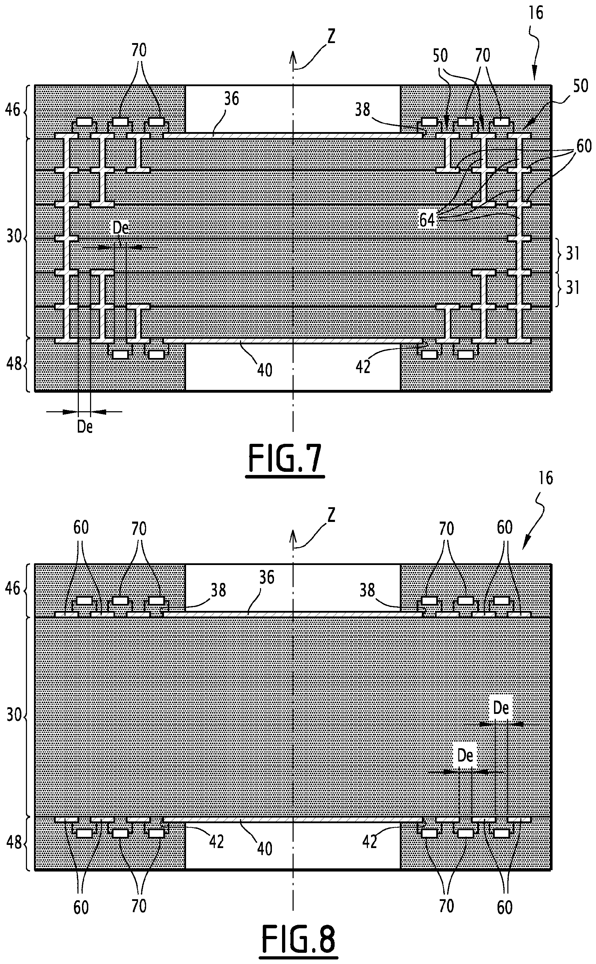

La figure 7 illustre un autre mode de réalisation ne faisant pas partie de l'invention pour lequel les éléments analogues au deuxième mode de réalisation décrit précédemment, sont repérés par des références identiques, et ne sont donc pas décrits à nouveau.

Selon ce mode de réalisation, chaque zone conductrice 50 comporte au moins un anneau de garde 60, mais ne comporte pas de couche intermédiaire disposée dans le substrat isolant 30. Le dispositif d'isolation 16 comporte, pour chaque anneau de garde 60, une résistance électrique 70 de connexion avec l'anneau de garde 60 voisin de potentiel électrique supérieur ou bien avec la couche extérieure 36, 40 correspondante. Les résistances électriques sont alors propres à imposer des valeurs distinctes de potentiel électrique d'un anneau de garde 60 à l'autre, ou bien de la couche extérieure 36, 40 à l'anneau de garde voisin.

Dans l'exemple de réalisation de le figure 7, le nombre N de zones conductrices 50 est égal à 5.

Une pluralité P d'anneaux de garde 60 sont disposés dans les plans des couches extérieures 36, 40, les P anneaux de garde étant espacés les uns des autres et du bord périphérique 38, 42 de la couche extérieure 36, 40 correspondante. Les P anneaux de garde 60 entourent de manière concentrique la couche extérieure 36, 40 correspondante, en étant sensiblement parallèles les uns par rapport aux autres, ainsi que par rapport au bord périphérique 38, 42 de la couche extérieure 36, 40 correspondante. Le nombre P d'anneaux de garde 60 est décroissant depuis le plan des couches extérieures 36, 40 jusque vers un plan sensiblement médian du substrat 30 comportant un seul anneau de garde, le plan médian étant perpendiculaire à l'axe Z.

Dans l'exemple de réalisation de la figure 7, P est égal à 3, et le nombre de potentiels électriques distincts dans les plans des couches extérieures 36, 40 est donc égal à 4.

Chaque anneau de garde 60 est électriquement connecté à un ou plusieurs autres anneaux de garde 60 agencés dans des plans distincts perpendiculaires à l'axe Z. Chaque anneau de garde 60 est obtenu par métallisation d'une strate isolante 31 correspondante du substrat isolant, chaque plan d'agencement d'un anneau de garde 60 correspondant à la limite entre deux strates 31.

Chaque liaison de connexion 64 reliant deux anneaux de garde 60 appartenant à des plans différents comporte, par exemple, un via métallisé. Dans l'exemple de réalisation de la figure 7, chaque liaison de connexion 64 comporte deux vias métallisés disposés dans le plan de coupe de la figure 4 et diamétralement opposés par rapport à l'axe vertical Z. En variante, la liaison de connexion 64 est constituée d'un unique via. En variante encore, la liaison de connexion 64 comporte quatre vias métallisés équirépartis autour de l'axe Z.

Les valeurs des potentiels électriques Vi des zones conductrices 50 sont décroissantes depuis le bord 38 de la première couche extérieure 36 vers l'extérieur du dispositif 16 et vers la seconde couche extérieure 40.

Le fonctionnement de ce mode de réalisation est analogue à celui du deuxième mode de réalisation, et n'est donc pas décrit à nouveau.

Les avantages de ce mode de réalisation sont analogues à celui du deuxième mode de réalisation, et ne sont donc pas décrits à nouveau.

La figure 8 illustre encore un autre mode de réalisation ne faisant pas partie de l'invention pour lequel les éléments analogues au mode de réalisation décrit précédemment, sont repérés par des références identiques, et ne sont donc pas décrits à nouveau.

Selon ce mode de réalisation, chaque zone conductrice 50 comporte un seul anneau de garde 60 disposé dans le plan de l'une des couches extérieures 36, 40 correspondante, mais ne comporte pas de couche intermédiaire ou d'anneau de garde disposés dans le substrat isolant 30. Le dispositif d'isolation 16 comporte, pour chaque anneau de garde 60, une résistance électrique 70 de connexion avec l'anneau de garde 60 voisin de potentiel électrique supérieur ou bien avec la couche extérieure 36, 40 correspondante. Les résistances électriques sont alors propres à imposer des valeurs distinctes de potentiel électrique d'un anneau de garde 60 à l'autre, ou bien de la couche extérieure 36, 40 à l'anneau de garde voisin.

Les moyens de diminution 44 comportent N zones conductrices 50, et les P d'anneaux de garde 60 sont disposés dans les plans des couches extérieures 36, 40, les P anneaux de garde étant espacés les uns des autres et du bord périphérique 38, 42 de la couche extérieure 36, 40 correspondante. Les anneaux de garde 60 entourent de manière concentrique la couche extérieure 36, 40 correspondante, en étant sensiblement parallèles les uns par rapport aux autres, ainsi que par rapport au bord périphérique 38, 42 de la couche extérieure 36, 40 correspondante.

Dans l'exemple de réalisation de la figure 8, les moyens de diminution 44 comportent N/2 anneaux de garde 60 dans le plan de chaque couche extérieure 36, 40. Autrement dit, P est égal à N/2, soit par exemple 3, N étant égal à 6, et le nombre de potentiels électriques distincts dans les plans des couches extérieures 36, 40 est donc égal à 4.

Les valeurs des potentiels électriques Vi des zones conductrices 50 sont décroissantes depuis le bord 38 de la première couche extérieure 36 vers l'extérieur du dispositif 16.

Le fonctionnement de ce mode de réalisation est analogue à celui du mode de réalisation selon la figure 7, et n'est donc pas décrit à nouveau.

Les avantages de ce mode de réalisation sont analogues à celui du mode de réalisation décrit précédemment, et ne sont donc pas décrits à nouveau.

On conçoit ainsi que le dispositif d'isolation électrique selon l'invention présente une tension de claquage plus importante tout en conservant une même épaisseur de substrat qu'un dispositif d'isolation de l'état de la technique, afin de ne pas augmenter la résistance thermique du substrat.

**Revendications**

1. Dispositif (16) d'isolation électrique d'un plan électriquement conducteur (18) propre à présenter un premier potentiel électrique (V1) par rapport à un deuxième potentiel électrique (V2), le dispositif (16) comprenant :

   - un substrat isolant (30) comportant deux surfaces planes (32, 34) parallèles l'une de l'autre,
   - une première couche extérieure (36), électriquement conductrice, sensiblement plane et disposée sur une première surface plane (32) du substrat isolant (30), la première couche extérieure (36) formant le plan électriquement conducteur (18) propre à être relié au premier potentiel (V1) et présentant un bord périphérique (38), la seconde surface (34) étant propre à être reliée au deuxième potentiel électrique (V2),
   - des moyens (44) de diminution de la valeur du champ électrostatique (E) en un point du bord périphérique (38) de la couche extérieure (36), les moyens de diminution (44) comportant au moins une zone électriquement conductrice (50) distincte de la première couche extérieure (36), disposée dans le substrat isolant (30), les moyens de diminution (44) étant propres à diminuer la valeur du champ électrostatique (E) en ce point par rapport à la valeur du champ électrostatique en ce point en l'absence de la zone conductrice, la zone conductrice (50) étant propre à présenter un potentiel électrique (Vi) de valeur strictement comprise entre les valeurs des premier (V1) et deuxième (V2) potentiels électriques,

   les moyens de diminution comportant N zones conductrices (50), N étant supérieur ou égal à 2, chaque zone conductrice (50) étant propre à présenter un potentiel électrique distinct (Vi) de valeur strictement comprise entre les valeurs des premier (V1) et deuxième (V2) potentiels électriques, les valeurs des potentiels électriques (Vi) des zones conductrices (50) étant décroissantes depuis le bord (38) de la première couche extérieure (36) vers la seconde surface (34),
   chaque zone conductrice (50) comportant une couche intermédiaire (62), électriquement conductrice et disposée dans le substrat isolant (30) parallèlement à la première couche extérieure (36), la couche intermédiaire (62) s'étendant au moins jusqu'à la translatée dans le plan de la couche intermédiaire (62) du bord périphérique (38) de la première couche extérieure suivant une direction normale (Z) au plan de la première couche extérieure (36), **caractérisé en ce que** chaque zone conductrice (50) comporte un anneau de garde (60) disposé dans le plan de chaque couche conductrice (36, 40, 62) à l'exception d'une couche intermédiaire centrale (66), l'anneau de garde (60) entourant la couche conductrice (36, 40, 62) correspondante, l'espacement entre le bord périphérique (38, 42, 68) de la couche conductrice (36, 40, 62) correspondante et l'anneau de garde (60) étant égal à une distance prédéterminée, chaque anneau de garde (60) étant électriquement connecté à une couche intermédiaire (62) présentant un potentiel différent de la couche conductrice (36, 40, 62) autour de laquelle il est agencé.

2. Dispositif (16) selon la revendication 1, dans lequel la première couche extérieure (36) forme une piste de circulation d'un courant électrique et constitue l'unique piste de circulation d'un courant électrique du dispositif (16).

3. Dispositif (16) selon la revendication 1 ou 2, dans lequel le dispositif (16) comprend en outre une seconde couche extérieure (40), électriquement conductrice, sensiblement plane et disposée sur la seconde surface plane (34) du substrat isolant (30).

4. Dispositif (16) selon l'une quelconque des revendications précédentes, dans lequel chaque zone conductrice (50) comporte des moyens (62, 64 ; 70) de fixation de la valeur du potentiel électrique de l'anneau de garde (60) à une valeur (Vi) strictement comprise entre les valeurs des premier (V1) et deuxième (V2) potentiels électriques.

5. Dispositif (16) selon la revendication 4, dans lequel P anneaux de garde (60) entourent de manière concentrique la ou chaque couche extérieure (36, 40) et sont disposés dans le plan de la ou chaque couche extérieure (36, 40), P étant supérieur ou égal à 2, les P anneaux de garde étant espacés les uns des autres et du bord périphérique (38, 42) de la couche extérieure (36, 40) correspondante.

6. Dispositif (16) selon la revendication 4 ou 5, dans lequel les moyens de fixation comportent, pour chaque anneau de garde (60), une couche intermédiaire (62), électriquement conductrice et disposée dans le substrat isolant (30) parallèlement à la première couche extérieure (36), et une liaison électrique (64) entre l'anneau de garde (60) et la couche intermédiaire (62) respectifs.

7. Dispositif (16) selon la revendication 4 ou 5, dans lequel les moyens de fixation comportent, pour chaque anneau de garde (60), une résistance électrique (70) de connexion avec l'anneau de garde (60) voisin de potentiel électrique supérieur ou bien avec la couche extérieure (36, 40) correspondante.

8. Dispositif (16) selon l'une quelconque des revendications précédentes, comprenant en outre une bordure (46, 48) de recouvrement du bord périphérique (38, 42) de la ou chaque couche extérieure (36, 40), la bordure de recouvrement (46, 48) étant électriquement isolante.

9. Système (10) d'alimentation électrique de composants électroniques (12), le système (10) comprenant :

   - une source d'alimentation (14) délivrant une tension électrique à un plan conducteur (18), le plan conducteur (18) présentant un premier potentiel électrique (V1) et étant propre à être connecté aux composants électroniques (12),
   - un dispositif (16) d'isolation électrique du plan conducteur (18) par rapport à un deuxième potentiel électrique (V2), et

   **caractérisé en ce que** le dispositif d'isolation (16) est conforme à l'une quelconque des revendications précédentes, la première couche extérieure (36) présentant le premier potentiel électrique (V1) et formant le plan conducteur (18), et la seconde surface (34) étant reliée au deuxième potentiel électrique (V2).

10. Utilisation de N zones électriquement conductrices (50), N étant supérieur ou égal à 2, distinctes par rapport à une première couche extérieure (36), électriquement conductrice, d'un dispositif (16) d'isolation électrique d'un plan électriquement conducteur (18) propre à présenter un premier potentiel électrique (V1) par rapport à un deuxième potentiel électrique (V2), pour diminuer la valeur du champ électrostatique (E) en un point du bord périphérique (38) de la première couche extérieure (36) par rapport à la valeur du champ électrostatique en ce point en l'absence de la zone conductrice, le dispositif (16) comprenant un substrat isolant (30) comportant deux surfaces planes (32, 34) parallèles l'une de l'autre, la première couche extérieure (36) sensiblement plane et disposée sur une première surface plane (32) du substrat isolant (30), la première couche extérieure (36) formant le plan électriquement conducteur (18) propre à être relié au premier potentiel (V1) et présentant un bord périphérique (38), et la seconde surface (34) étant propre à être reliée au deuxième potentiel électrique (V2), chaque zone conductrice (50) étant disposée dans le substrat isolant (30), et chaque zone conductrice (50) étant propre à présenter un potentiel électrique de valeur (Vi) strictement comprise entre les valeurs des premier (V1) et deuxième (V2) potentiels électriques, chaque zone conductrice (50) étant propre à présenter un potentiel électrique distinct (Vi) de valeur strictement comprise entre les valeurs des premier (V1) et deuxième (V2) potentiels électriques, les valeurs des potentiels électriques (Vi) des zones conductrices (50) étant décroissantes depuis le bord (38) de la première couche extérieure (36) vers la seconde surface (34), chaque zone conductrice (50) comportant une couche intermédiaire (62), électriquement conductrice et disposée dans le substrat isolant (30) parallèlement à la première couche extérieure (36), la couche intermédiaire (62) s'étendant au moins jusqu'à la translatée dans le plan de la couche intermédiaire (62) du bord périphérique (38) de la première couche extérieure suivant une direction normale (Z) au plan de la première couche extérieure (36), et chaque zone conductrice (50) comportant un anneau de garde (60) disposé dans le plan de chaque couche conductrice (36, 40, 62) à l'exception d'une couche intermédiaire centrale (66), l'anneau de garde (60) entourant la couche conductrice (36, 40, 62) correspondante, l'espacement entre le bord périphérique (38, 42, 68) de la couche conductrice (36, 40, 62) correspondante et l'anneau de garde (60) étant égal à une distance prédéterminée, chaque anneau de garde (60) étant électriquement connecté à une couche intermédiaire (62) présentant un potentiel différent de la couche conductrice (36, 40, 62) autour de laquelle il est agencé.

**Patentansprüche**

1. Vorrichtung (16) zur elektrischen Isolation einer elektrisch leitenden Ebene (18), welche imstande ist, ein erstes elektrisches Potenzial (V1) bezüglich eines zweiten elektrischen Potenzials (V2) zu haben, wobei die Vorrichtung (16) aufweist:

   - ein isolierendes Substrat (30), welches zwei ebene Flächen (32, 34) hat, welche zueinander parallel sind,
   - eine erste äußere Schicht (36), welche elektrisch leitend, im Wesentlichen eben und auf einer ersten ebenen Fläche (32) des isolierenden Substrats (30) angeordnet ist, wobei die erste äußere Schicht (36) die elektrisch leitende Ebene (18) bildet, welche imstande ist, mit dem ersten Potenzial (V1) verbunden zu sein, und einen Umfangsrand (38) hat,
   wobei die zweite Fläche (34) imstande ist, mit dem zweiten elektrischen Potenzial (V2) verbunden zu sein,
   - Mittel (44) zum Verringern des Werts des elektrostatischen Feldes (E) in einem Punkt des Umfangsrandes (38) der äußeren Schicht (36), wobei die Mittel zum Verringern (44) mindestens eine von der ersten äußeren Schicht (36) verschiedene elektrisch leitende Zone (50) aufweisen, welche in dem isolierenden Substrat (30) angeordnet ist, wobei die Mittel zum Verringern (44) imstande sind, den Wert des elektrostatischen Feldes (E) in diesem Punkt bezüglich des Wertes des elektrostatischen Feldes in diesem Punkt in der Abwesenheit der leitenden Zone zu verringern, wobei die leitende Zone (50) imstande ist, ein elektrisches Potenzial (Vi) eines Wertes zu haben, welcher streng zwischen den Werten des ersten (V1) und des zweiten (V2) elektrischen Potenzials enthalten ist,

wobei die Mittel zum Verringern N leitende Zonen (50) aufweisen, wobei N größer oder gleich 2 ist, wobei jede leitende Zone (50) imstande ist, ein unterschiedliches elektrisches Potenzial (Vi) mit einem Wert zu haben, welcher streng zwischen den Werten des ersten (V1) und des zweiten (V2) elektrischen Potenzials enthalten ist, wobei die Werte der elektrischen Potenziale (Vi) der leitenden Zonen (50) von dem Rand (38) der ersten äußeren Schicht (36) zur zweiten Fläche (34) abnehmend sind,

wobei jede leitende Schicht (50) eine Zwischenschicht (62) aufweist, welche elektrisch leitend und in dem isolierenden Substrat (30) parallel zur ersten äußeren Schicht (36) angeordnet ist, wobei sich die Zwischenschicht (62) mindestens bis zum entlang einer Normalenrichtung (Z) zur Ebene der ersten äußeren Schicht (36) in die Ebene der Zwischenschicht (62) Verschobenen des Umfangsrandes (38) der ersten äußeren Schicht erstreckt, **dadurch gekennzeichnet, dass** jede leitende Zone (50) einen Schutzring (60) aufweist, welcher in der Ebene von jeder leitenden Schicht (36, 40, 62) mit Ausnahme einer zentralen Zwischenschicht (66) angeordnet ist, wobei der Schutzring (60) die korrespondierende leitende Schicht (36, 40, 62) umgibt, wobei der Abstand zwischen dem Umfangsrand (38, 42, 68) der korrespondierenden leitenden Schicht (36, 40, 62) und dem Schutzring (60) gleich einem vorbestimmten Abstand ist, wobei jeder Schutzring (60) mit einer Zwischenschicht (62) elektrisch verbunden ist, welche ein Potenzial hat, welches von der leitenden Schicht (36, 40, 62), um welche herum er angeordnet ist, verschieden ist.

2. Vorrichtung (16) gemäß Anspruch 1, wobei die erste äußere Schicht (36) eine Bahn zum Fließen eines elektrischen Stroms bildet und die einzige Bahn zum Fließen eines elektrischen Stroms der Vorrichtung (16) bildet.

3. Vorrichtung gemäß Anspruch 1 oder 2, wobei die Vorrichtung (16) ferner eine zweite äußere Schicht (40) aufweist, welche elektrisch leitend, im Wesentlichen eben und auf der zweiten ebenen Fläche (34) des isolierenden Substrats (30) angeordnet ist.

4. Vorrichtung (16) gemäß irgendeinem der vorherigen Ansprüche, wobei jede leitende Zone (50) aufweist Mittel (62, 64; 70) zum Festlegen des Wertes des elektrischen Potenzials des Schutzrings (60) auf einen Wert (Vi), welcher streng enthalten ist zwischen den Werten des ersten (V1) und des zweiten (V2) elektrischen Potenzials.

5. Vorrichtung (16) gemäß Anspruch 4, wobei P Schutzringe (60) auf konzentrische Weise die oder jede äußere Schicht (36, 40) umgeben und in der Ebene der oder jeder äußeren Schicht (36, 40) angeordnet sind, wobei P größer oder gleich 2 ist, wobei die P Schutzringe im Abstand voneinander und von dem Umfangsrand (38, 42) der korrespondierenden äußeren Schicht (36, 40) sind.

6. Vorrichtung (16) gemäß Anspruch 4 oder 5, wobei die Mittel zum Festlegen aufweisen, für jeden Schutzring (60), eine Zwischenschicht (62), welche elektrisch leitend und in dem isolierenden Substrat (30) parallel zur ersten äußeren Schicht (36) ist, und eine elektrische Verbindung (64) zwischen dem Schutzring (60) und der jeweiligen Zwischenschicht (62).

7. Vorrichtung (16) gemäß Anspruch 4 oder 5, wobei die Mittel zum Festlegen aufweisen, für jeden Schutzring (60), einen elektrischen Widerstand (70) der Verbindung mit dem benachbarten Schutzring (60) mit höherem elektrischen Potenzial oder mit der korrespondierenden äußeren Schicht (36, 40).

8. Vorrichtung (16) gemäß irgendeinem der vorherigen Ansprüche, welche ferner aufweist eine Einfassung (46, 48) zum Abdecken des Umfangsrandes (38, 42) der oder jeder äußeren Schicht (36, 40), wobei die Einfassung zum Abdecken (46, 48) elektrisch isolierend ist.

9. System (10) zur elektrischen Versorgung von elektronischen Komponenten (12), wobei das System (10) aufweist:

- eine Quelle zur Versorgung (14), welche eine elektrische Spannung zu einer leitenden Ebene (18) liefert, wobei die leitende Ebene (18) ein erstes elektrisches Potenzial (V1) hat und imstande ist, mit den elektronischen Komponenten (12) verbunden zu sein,

- eine Vorrichtung (16) zur elektrischen Isolation der leitenden Ebene (18) bezüglich eines zweiten elektrischen Potenzials (V2) und

**dadurch gekennzeichnet, dass** die Vorrichtung zur Isolation (16) irgendeinem der vorherigen Ansprüche entspricht, wobei die erste äußere Schicht (36) das erste elektrische Potenzial (V1) hat und die leitende Ebene (18) bildet und die zweite Fläche (34) mit dem zweiten elektrischen Potenzial (V2) verbunden ist.

10. Verwendung von N elektrisch leitenden Zonen (50), wobei N größer oder gleich 2 ist, welche bezüglich einer elektrisch leitenden ersten äußeren Schicht (36) verschieden sind, von einer Vorrichtung (16) zur elektrischen Isolation von einer elektrisch leitenden Ebene (18), welche imstande ist, ein erstes elektrisches Potenzial (V1) bezüglich eines zweiten elektrischen Potenzials (V2) zu haben, um den Wert des elektrostatischen Feldes (E) in einem Punkt des Umfangsrandes (38) der ersten äußeren Schicht (36) bezüglich des Wertes des elektrostatischen Feldes in diesem Punkt in der Abwesenheit der leitenden Zone zu verringern, wobei die Vorrichtung (16) ein isolierendes Substrat (30) aufweist, welches zwei ebene Flächen (32, 34) hat, welche zueinander parallel sind, wobei die erste äußere Schicht (36) im Wesentlichen eben und auf einer ersten ebenen Fläche (32) des isolierenden Substrats (30) angeordnet ist, wobei die erste äußere Schicht (36) die elektrisch leitende Ebene (18) bildet, welche imstande ist, mit dem ersten Potenzial (V1) verbunden zu sein, und einen Umfangsrand (38) aufweist, und die zweite Fläche (34) imstande ist, mit dem zweiten elektrischen Potenzial (V2) verbunden zu sein, wobei jede leitende Zone (50) in dem isolierenden Substrat (30) angeordnet ist, und wobei jede leitende Zone (50) imstande ist, ein elektrisches Potenzial eines Wertes (Vi) zu haben, welcher streng zwischen den Werten des ersten (V1) und des zweiten (V2) elektrischen Potenzials enthalten ist,
wobei jede leitende Zone (50) imstande ist, ein unterschiedliches elektrisches Potenzial (Vi) mit einem Wert zu haben, welcher streng zwischen den Werten des ersten (V1) und des zweiten (V2) elektrischen Potenzials enthalten ist, wobei die Werte der elektrischen Potenziale (Vi) der leitenden Zonen (50) von dem Rand (38) der ersten äußeren Schicht (36) zur zweiten Fläche (34) abnehmend sind,
wobei jede leitende Schicht (50) eine Zwischenschicht (62) aufweist, welche elektrisch leitend und in dem isolierenden Substrat (30) parallel zur ersten äußeren Schicht (36) angeordnet ist, wobei sich die Zwischenschicht (62) mindestens bis zum entlang einer Normalenrichtung (Z) zur Ebene der ersten äußeren Schicht (36) in die Ebene der Zwischenschicht (62) Verschobenen des Umfangsrandes (38) der ersten äußeren Schicht erstreckt, und
wobei jede leitende Zone (50) einen Schutzring (60) aufweist, welcher in der Ebene von jeder leitenden Schicht (36, 40, 62) mit Ausnahme einer zentralen Zwischenschicht (66) angeordnet ist, wobei der Schutzring (60) die korrespondierende leitende Schicht (36, 40, 62) umgibt, wobei der Abstand zwischen dem Umfangsrand (38, 42, 68) der korrespondierenden leitenden Schicht (36, 40, 62) und dem Schutzring (60) gleich einem vorbestimmten Abstand ist, wobei jeder Schutzring (60) mit einer Zwischenschicht (62) elektrisch verbunden ist, welche ein Potenzial hat, welches von der leitenden Schicht (36, 40, 62), um welche herum er angeordnet ist, verschieden ist.

## Claims

1. A device (16) for electric insulation of an electrically conducting plane (18) capable of having a first electrical potential (V1) relatively to a second electric potential (V2), the device (16) comprising:

   - an insulating substrate (30) including two planar surfaces (32, 34) parallel to each other,
   - a first outer layer (36), electrically conducting, substantially planar and positioned on a first planar surface (32) of the insulating substrate (30), the first outer layer (36) forming the electrically conducting plane (18) able to be connected to the first potential (V1) and having a peripheral edge (38),
   the second surface (34) being able to be connected to the second electric potential (V2),
   - reducing means (44) for reducing the value of the electrostatic field (E) in a point of the peripheral edge (38) of the outer layer (36), the reducing means (44) including at least one electrically conducting area (50) distinct from the first outer layer (36), positioned in the insulating substrate (30), the reducing means (44) being able to reduce the value of the electrostatic field (E) in this point relatively to the value of the electrostatic field in this point in the absence of the conducting area, the conducting area (50) being capable of having an electric potential (Vi) with a value strictly comprised between the values of the first (V1) and second (V2) electric potentials,

   the reducing means include N conducting areas (50), N being greater than or equal to 2, each conducting area (50) being capable of having a distinct electric potential (Vi) of a value strictly comprised between the values of the first (V1) and second (V2) electric potentials, the values of the electric potentials (Vi) of the conducting areas (50) decreasing from the edge (38) of the first outer layer (36) towards the second surface (34),

each conducting area (50) including an intermediate layer (62), electrically conducting and positioned in the insulating substrate (30) parallel to the first outer layer (36), the intermediate layer (62) extending at least up to the equivalent in the plane of the intermediate layer (62), of the peripheral edge (38) of the first outer layer, translated along a direction (Z) normal to the plane of the first outer layer (36),

**characterized in that** each conducting area (50) includes a guard ring (60) positioned in the plane of each conducting layer (36, 40, 62) except for a central intermediate layer (66), the guard ring (60) surrounding the corresponding conducting layer (36, 40, 62), the spacing between the peripheral edge (38, 42, 68) of the corresponding conducting layer (36, 40, 62) and the guard ring (60) being equal to a predetermined distance, each guard ring (60) being electrically connected to an intermediate layer (62) having a potential different than the one of the conducting layer (36, 40, 62) around which it is laid out.

2. The device (16) according to claim 1, wherein the first outer layer (36) forms a track for circulating an electric current and forms the only track for circulating an electric current of the device (16).

3. The device (16) according to claim 1 or 2, wherein the device (16) further comprises a second outer layer (40), electrically conducting, substantially planar and positioned on the second planar surface (34) of the insulating substrate (30).

4. The device (16) according to any of the preceding claims, wherein each conducting area (50) includes setting means (62, 64; 70) for setting the value of the electric potential of the guard ring (60) to a value (Vi) strictly comprised between the values of the first (V1) and second (V2) electric potentials.

5. The device (16) according to claim 4, wherein P guard rings (60) concentrically surround said or each outer layer (36, 40) and are positioned in the plane of said or each outer layer (36, 40), P being greater than or equal to 2, the P guard rings being spaced apart from each other and from the peripheral edge (38, 42) of the corresponding outer layer (36, 40).

6. The device (16) according to claim 4 or 5, wherein the setting means include, for each guard ring (60), an intermediate layer (62), electrically conducting and positioned in the insulating substrate (30) parallel to the first outer layer (36), and an electric link (64) between the respective guard ring (60) and the respective intermediate layer (62).

7. The device (16) according to claim 4 or 5, wherein the setting means include, for each guard ring (60), an electric resistor (70) for connection with the neighboring guard ring (60) of greater electric potential or else with the corresponding outer layer (36, 40).

8. The device (16) according to any of the preceding claims, further comprising a covering border (46, 48) for covering the peripheral edge (38, 42) of said or each outer layer (36, 40), the covering border (46, 48) being electrically insulating.

9. An electric power supply system (10) for electronic components (12), the system (10) comprising:

   - a power supply source (14) delivering an electric voltage to a conducting plane (18), the conducting plane (18) having a first electric potential (V1) and being able to be connected to the electronic components (12),
   - an insulation device (16) for electric insulation of the conducting plane (18) relatively to a second electric potential (V2), and

   **characterized in that** the insulation device (16) is according to any of the preceding claims, the first outer layer (36) having the first electric potential (V1) and forming the conducting plane (18), and the second surface (34) being connected to the second electric potential (V2).

10. The use of N electrically conducting areas (50), N being greater than or equal to 2, distinct relatively to a first electrically conducting outer layer (36) of a device (16) for electric insulation of an electrically conducting plane (18) capable of having a first electric potential (V1) relatively to a second electric potential (V2), for reducing the value of the electrostatic field (E) in a point of the peripheral edge (38) of the first outer layer (36) relatively to the value of the electrostatic field in this point in the absence of the conducting area, the device (16) comprising an insulating substrate (30) including two planar surfaces (32, 34) parallel to each other, the first outer layer (36) substantially planar and positioned on a first planar surface (32) of the insulating substrate (30), the first outer layer (36) forming the electrically conducting plane (18) able to be connected to the first potential (V1) and having a peripheral edge (36), and the second surface (34) being able to be connected to the second electric potential (V2), each conducting area (50) being positioned in the insulating substrate (30), and each conducting area (50) being capable of having an electric potential of value (Vi) strictly comprised between the values of the first (V1) and second (V2) electric potentials,

each conducting area (50) being capable of having a distinct electric potential (Vi) of a value strictly comprised between the values of the first (V1) and second (V2) electric potentials, the values of the electric potentials (Vi) of the conducting areas (50) decreasing from the edge (38) of the first outer layer (36) towards the second surface (34), each conducting area (50) including an intermediate layer (62), electrically conducting and positioned in the insulating substrate (30) parallel to the first outer layer (36), the intermediate layer (62) extending at least up to the equivalent in the plane of the intermediate layer (62), of the peripheral edge (38) of the first outer layer, translated along a direction (Z) normal to the plane of the first outer layer (36), and

each conducting area (50) including a guard ring (60) positioned in the plane of each conducting layer (36, 40, 62) except for a central intermediate layer (66), the guard ring (60) surrounding the corresponding conducting layer (36, 40, 62), the spacing between the peripheral edge (38, 42, 68) of the corresponding conducting layer (36, 40, 62) and the guard ring (60) being equal to a predetermined distance, each guard ring (60) being electrically connected to an intermediate layer (62) having a potential different than the one of the conducting layer (36, 40, 62) around which it is laid out.

## FIG.1

## FIG.2

**FIG.3**

**FIG.4**

FIG.5

FIG.6

## FIG.7

## FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2002066953 A1